# EUROPÄISCHE PATENTANMELDUNG

(11) **EP 2 629 102 A2**
(43) Veröffentlichungstag der Anmeldung: **21.08.2013**
(21) Anmeldenummer: 13000143.1
(22) Anmeldetag: 11.01.2013
(51) Int. Cl.: G01R 15/24

(54) **Integrierter optischer schaltkreis und verfahren zur strommessung sowie sensormodul und messeinrichtung**

(30) Priorität: 15.02.2012 DE 102012002984
(71) Anmelder: Northrop Grumman LITEF GmbH, 79115 Freiburg (DE)
(72) Erfinder: Dorner, Georg, 79189 Bad Krozingen (DE); Voigt, Sven, 79111 Freiburg (DE); Koos, Christian, 74936 Siegelsbach (DE); Freude, Wolfgang, 76199 Karlsruhe (DE); Leuthold, Jürg, 75045 Walzbachtal (DE)
(74) Vertreter: Müller - Hoffmann & Partner

(57) **Zusammenfassung**

In einem integrierten optischen Schaltkreis (100) wird Licht einer Lichtquelle (110) polarisiert und auf einen ersten und zweiten Streifenwellenleiter (141, 142) gekoppelt. Ein Wellenleiter-Koppelelement (160) koppelt die beiden optischen Signale von den beiden Streifenwellenleitern (141, 142) auf unterschiedliche Polarisationsmoden einer optischen Faserleitung (202) ein. Die optische Faserleitung (202) ist mit einem Messkopf verbunden, der das optische Signal reflektiert und in dem in einem Magnetfeld eine Phasendifferenz zwischen den beiden optischen Teilsignalen moduliert wird. Das reflektierte Signal wird im Wellenleiter-Koppelelement (160) in zwei optische Teilsignale gleicher Polarisation aufgespalten und die Phasendifferenz zwischen den beiden Teilsignalen ermittelt. Eine Phasenmodulatoreinrichtung (150) ermöglicht einen Closed-Loop-Betrieb. Gegenüber faseroptischen Konzepten ist die Anzahl von Spleißen reduziert.

## Beschreibung

Die Erfindung bezieht sich auf einen integrierten optischen Schaltkreis zur Strommessung auf Grundlage des Faraday-Effekts, ein Sensormodul mit einem solchen integrierten optischen Schaltkreis und eine Messeinrichtung. Die Erfindung bezieht sich ferner auf ein Verfahren zur Strommessung mittels eines integrierten optischen Schaltkreises.

Faseroptische Stromsensoren (FOCS, fibre-optical current sensor) erfassen den Strom durch einen Leiter mittels einer um den Leiter gewundenen Glasfaser. Das den Leiter umgebende Magnetfeld dreht die Licht-Schwingungsebene von linearpolarisiertem Licht oder bewirkt eine Phasenverschiebung zwischen zueinander orthogonalen zirkularen Polarisationsmoden eines durch die Glasfaser geführten Lichtstrahls. Der Betrag der durch den elektrischen Strom bewirkten Phasenverschiebung zwischen den Polarisationsmoden ist ein Maß für die Stromstärke im Leiter.

In einem faseroptischen Stromsensor wird ein von einer Lichtquelle erzeugter Lichtstrahl über einen Richtkoppler zu einem Polarisator geführt und vom Polarisator linear polarisiert. Das polarisierte Licht wird mittels eines Faserspleißes unter 45 Grad gegen die Polarisationsachsen einer polarisationserhaltenden Faser eingekoppelt, so dass in der gleichen Faser zwei verschiedene Polarisationsmoden mit annähernd gleicher Amplitude parallel geführt werden. Die beiden Polarisationsmoden sind parallel geführte "Teil-Lichtstrahlen" eines Primärlichtstrahls mit einer definierten Polarisation und benutzen in der polarisationserhaltenden Faser jeweils einen anderen optischen Lichtweg. Die beiden Polarisationsmoden durchlaufen einen Doppelbrechungs-Phasenmodulator, über den eine nicht-reziproke Phasenverschiebung zwischen den beiden Polarisationsmoden eingestellt wird. Ein λ/4-Phasenschieber konvertiert das linear polarisierte Licht in zirkular polarisiertes Licht um die Wirkung des Faraday-Effekts zu verbessern. Danach durchläuft das Licht eine Faserspule, die den Leiter mit dem zu messenden Strom umschlingt, und wird in einem Reflektor reflektiert. Fließt in dem Leiter ein Strom, so bewirkt der Faraday-Effekt zwischen den beiden zirkular polarisierten Polarisationsmoden eine Phasenverschiebung, deren Betrag proportional dem Strom im Leiter ist. Die zurücklaufenden Polarisationsmoden werden am Faserspleiß zusammengeführt und über den Polarisator und den Richtkoppler auf einen Detektor geführt, auf dem die beiden Polarisationsmoden interferieren. Die Phasenverschiebung schlägt sich in einer Verschiebung des Interferenzmusters nieder, die ausgewertet wird.

Der vorliegenden Erfindung liegt die Aufgabe zugrunde, eine Messanordnung zur Strommessung auf Grundlage des Faraday-Effekts zur Verfügung zu stellen, die kostengünstig herzustellen ist. Die Aufgabe wird durch den Gegenstand der unabhängigen Ansprüche gelöst. Vorteilhafte Weiterbildungen ergeben sich aus den Unteransprüchen.

Im Nachfolgenden werden anhand der Figuren Ausführungsformen der Erfindung, deren Funktionsweise sowie deren Vorteile beschrieben. Elemente der Ausführungsformen sind miteinander kombinierbar, sofern sie sich nicht ausschließen.

Die Figur 1A zeigt eine schematische Draufsicht auf ein optisches Modul eines integrierten optischen Schaltkreises.

Die Figur 1B zeigt eine schematische Darstellung einer Messeinrichtung zur Messung eines Stroms auf Grundlage des Faraday-Effekts mittels eins integrierten optischen Schaltkreises mit dem optischen Modul nach Figur 1A.

Die Figur 2A zeigt eine schematische Draufsicht eines integrierten optischen Schaltkreises mit einem optischen Modul gemäß einer Ausführungsform mit einem Wellenleiter-Kombinierelement und einem Wellenleiter-Verzweigungselement.

Die Figur 2B zeigt eine schematische Draufsicht auf einen integrierten optischen Schaltkreis gemäß einer Ausführungsform mit einem optischen Modul mit einem 2:2-Richtkoppelelement.

Die Figur 3 zeigt eine schematische Draufsicht auf ein Sensormodul mit einem integrierten optischen Schaltkreis, einer Lichtquelle, einem Detektorelement und einer Auswerte- und Steuereinheit gemäß einer hybriden Ausführungsform.

Die Figur 4 zeigt eine schematische Draufsicht auf ein Sensormodul mit einem integrierten optischen Schaltkreis, bei dem Lichtquelle, Detektorelement und Auswerte- und Steuereinheit monolithisch integriert sind.

Die Figur 5A zeigt eine schematische Draufsicht auf ein Raumfilterelement für einen integrierten optischen Schaltkreis gemäß einer Ausführungsform mit einer Einfachbiegung.

Die Figur 5B zeigt eine schematische Draufsicht auf ein Raumfilterelement gemäß einer Ausführungsform mit einer Doppelbiegung.

Die Figur 5C zeigt eine schematische Draufsicht auf ein Raumfilterelement gemäß einer Ausführungsform mit einer Querschnittsverengung eines Streifenwellenleiters.

Die Figur 5D zeigt eine schematische Draufsicht auf ein Raumfilterelement gemäß einer Ausführungsform mit unterschiedlichen Wellenleitergeometrien.

Die Figur 6 zeigt eine schematische Draufsicht auf einen integrierten optischen Schaltkreis mit drei optischen Modulen zur Messung von Drei-Phasen-Strömen.

Die Figur 7 zeigt eine schematische Darstellung einer Messeinrichtung zur Messung von Drei-Phasen-Strömen mittels des integrierten optischen Schaltkreises gemäß Figur 6.

Die Figur 8 zeigt eine schematische Draufsicht auf einen integrierten optischen Schaltkreis umfassend einen 1:3-Koppler und drei 2:2-Koppler zur Messung von Drei-Phasen-Strömen.

Die Figur 9 ist ein vereinfachtes Flussdiagramm für ein Verfahren zum Betrieb einer Messeinrichtung.

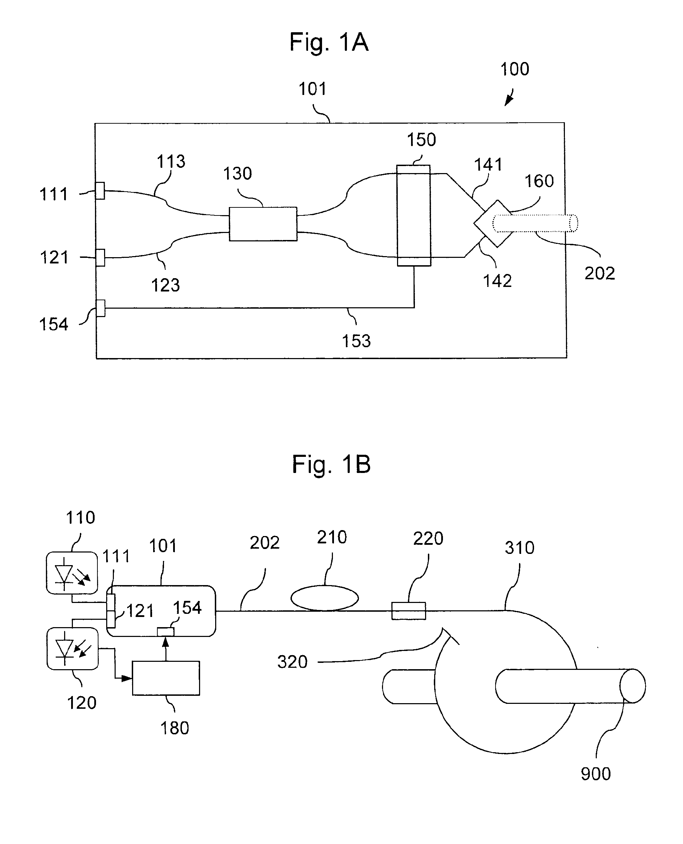

Die Figur 1A zeigt einen integrierten optischen Schaltkreis 100 zur Strommessung auf Grundlage des Faraday-Effekts. Der integrierte optische Schaltkreis 100 weist eines oder mehrere Messmodule 101 auf. Jedes Messmodul 101 umfasst einen ersten Streifenwellenleiter 141 und einen zweiten Streifenwellenleiter 142. Nach einer Ausführungsform ist das Material der Streifenwellenleiter 141, 142 polarisationserhaltend. Nach einer anderen Ausführungsform ist das Material der Streifenwellenleiter 141, 142 ein hoch anisotroper, polarisierender Werkstoff. Beispielsweise ist das Material der Streifenwellenleiter 141, 142 ein Halbleitermaterial, z.B. GaAs oder Silizium.

Die Streifenwellenleiter 141, 142 können jeweils vollständig oder teilweise als aufliegende Streifenwellenleiter, die auf einem Substrat mit niedrigerer Brechzahl aufliegen, als vergrabene Streifenwellenleiter, die in ein Substrat mit niedrigerer Brechzahl eingebettet sind, als Schlitzwellenleiter (slotted waveguide) oder als Nano-Rippen-Wellenleiter (nano rib waveguide) ausgeführt sein. Das den Streifenwellenleitern 141, 142 unterliegende Substrat ist beispielsweise monokristallines Silizium, Siliziumdioxid oder Glas. Die Breite der Streifenwellenleiter 141 , 142 beträgt 100 Mikrometer oder weniger. Gemäß einer Ausführungsform ist die Breite in der Größenordnung von oder kleiner als die Wellenlänge des in den Streifenwellenleitern 141, 142 geführten Lichts. Beispielsweise beträgt die Breite der Streifenwellenleiter 141, 142 mindestens in Abschnitten maximal 1 Mikrometer oder maximal 300 nm.

Der integrierte optische Schaltkreis 100 weist ferner ein Wellenleiter-Koppelelement 160 auf. Das Wellenleiter-Koppelelement 160 koppelt sowohl das über den ersten Streifenwellenleiter 141 als auch das über den zweiten Streifenwellenleiter 142 herangeführte Lichtsignal auf eine optische Faserleitung 202. Dabei koppelt das Wellenleiter-Koppelelement 160 die beiden Lichtsignale auf unterschiedliche Polarisationsmoden der optischen Faserleitung 202. Umgekehrt koppelt es zwei orthogonale Polarisationsmoden eines über die optische Faserleitung 202 herangeführten Lichtstrahls in Abhängigkeit von der Polarisationsrichtung entweder auf den ersten Streifenwellenleiter 141 oder den zweiten Streifenwellenleiter 142. Das Wellenleiter-Koppelelement 160 ist beispielsweise ein Auskoppelgitter und eine Stirnfläche der optischen Faserleitung 202 ist im Wesentlichen parallel zur Gitteroberfläche ausgerichtet oberhalb des Auskoppelgitters angeordnet. Beispielsweise koppelt das Auskoppelgitter die beiden über die beiden Streifenwellenleiter 141, 142 herangeführten optischen Signale in orthogonale lineare Polarisationszustände der optischen Faserleitung 202 ein. Das Auskoppelgitter ist beispielsweise ein zweidimensionales Gitter in einem Überlappungsbereich des ersten und des zweiten Streifenwellenleiters 141, 142.

Die Abmessungen des Auskoppelgitters können an den Querschnitt der Faserleitung angepasst sein. Beispielsweise kann das Auskoppelgitter eine Fläche von weniger als 1 mm² umfassen. Die Kantenlänge kann zwischen mehreren 10 und mehreren 100 Mikrometern betragen. Die beiden Streifenwellenleiter 141, 142 schneiden sich beispielsweise im Auskoppelgitter in einem Winkel von 90 Grad. Die Breite der Streifenwellenleiter 141, 142 kann dabei in einem Übergangsabschnitt ausgehend von einer Weite von mehreren zehn oder hundert Nanometern an die Kantenlänge des Auskoppelgitters stetig oder linear angepasst werden. Nach einer Ausführungsform ist das Gitter in eine mehrere 10 bis mehrere 100 nm dicke Siliziumschicht geätzt, die auf einer SiO₂-Schicht aufliegt. Das Gitter umfasst beispielsweise ein regelmäßiges Feld von Vertiefungen mit einer Tiefe von 90 nm und einem Durchmesser der Vertiefungen von etwa 300 nm bei einer Gitterperiode von 580 nm.

Der integrierte optische Schaltkreis 100 umfasst ferner eine Phasenmodulatoreinrichtung 150 über die sich ein Phasenunterschied zwischen den beiden Lichtsignalen gleicher Polarisation im ersten und zweiten Streifenwellenleiter 141, 142 steuern lässt. Zur Ansteuerung der Phasenmodulatoreinrichtung 150 weist das optische Modul 101 eine oder mehrere elektrische Leitungen 153 auf, die zwischen einer elektrischen Schnittstelle 154 des optischen Moduls 101 und der Phasenmodulatoreinrichtung 150 geführt sind.

Ein Richtkoppelelement 130 zweigt die beiden über die beiden Streifenwellenleiter 141, 142 zur optischen Faserleitung 202 geführten optischen Lichtsignale aus einem gemeinsamen optischen Eingangssignal ab und führt ferner die beiden von der optischen Faserleitung 202 empfangenen optischen Teilsignale zu einem gemeinsamen Ausgangssignal zusammen. Ein weiterer Streifenwellenleiter 113 verbindet das Richtkoppelelement 130 mit einem Eingangstor 111, über das das optische Eingangsignal in das optische Modul 101 eingekoppelt wird. Das optische Ausgangssignal wird über ein Ausgangstor 121 ausgegeben, das über einen weiteren Streifenwellenleiter 123 mit dem Richtkoppelelement 130 verbunden ist.

Die Phasenmodulatoreinrichtung 150 kann beispielsweise ein elektrooptischer Phasenmodulator vom Push-Pull-Typ sein. Gemäß einer Ausführungsform umfasst die Phasenmodulatoreinrichtung 150 genau eine Modulatoreinheit in jedem der beiden optischen Signalpfade mit den ersten und zweiten Streifenwellenleitern 141, 142. Da die Phasenmodulatoreinrichtung 150 letztlich lediglich den Phasenunterschied zwischen den beiden optischen Signalen in den beiden durch den ersten und zweiten Streifenwellenleiter 141, 142 definierten optischen Signalpfaden einstellt, umfasst die Phasenmodulatoreinrichtung 150 in einer anderen Ausführungsform genau eine Modulatoreinheit in einem der beiden optischen Signalpfade. Jede Modulatoreinheit kann einteilig sein. Gemäß einer Ausführungsform ist mindestens eine der Modulatoreinheiten segmentiert, wobei sich die Segmente unabhängig voneinander ansteuern lassen. Beispielsweise kann eines der Segmente zur Einstellung eines festen Phasen-Offsets und damit eines bestimmten Arbeitspunkts verwendet werden, während ein weiteres Segment überwiegend oder ausschließlich der hochfrequenten Modulation des Messsignals dient. Gemäß einer Ausführungsform sind mehrere Segmente einer Modulatoreinheit in der Art eines digitalen Phasenmodulators (optischen DA-Wandlers) ausgebildet.

Das Richtkoppelelement 130 ist beispielsweise ein integriert-optischer 2:2 Richtkoppler mit einem Phasenunterschied von 90°C zwischen den beiden ausgangsseitigen optischen Signalen. Das Richtkoppelelement 130 speist ein optisches Eingangssignal an einem ersten Tor eines ersten Torpaares auf ein erstes oder zweites Tor eines zweiten Torpaares und optische Signale an den Toren des zweiten Torpaares auf das zweite Tor des ersten Torpaares. Im optischen Modul 101 führt das Richtkoppelelement 130 ein am Eingangstor 111 eingespeistes optisches Eingangssignal auf den ersten und zweiten Streifenwellenleiter 141, 142. Zudem koppelt das Richtkoppelelement 130 die von der optischen Faserleitung 202 empfangenen und auf die ersten und zweiten Streifenwellenleiter 141, 142 gekoppelten optischen Teilsignale auf den Streifenwellenleiter 123, der mit dem Ausgangstor 121 des optischen Moduls 101 verbunden ist.

Ein erster optischer Signalpfad mit dem ersten Streifenwellenleiter 141 zwischen dem ersten Tor des zweiten Torpaares des Richtkoppelelements 130 und dem Wellenleiter-Koppelelement 160 weist eine andere optische Wegstrecke auf als der zweite optische Signalpfad mit dem zweiten Streifenwellenleiter 142 zwischen dem zweiten Tor des zweiten Torpaares des Richtkoppelelements 130 und dem Wellenleiter-Koppelelement 160. Der optische Wegunterschied bewirkt, dass ein Interferenzkontrast der optischen Signale im Wellenleiter-Koppelelement 160 im Vergleich zu einer gedachten Ausführung mit identischen Weglängen um mindestens 50 %, beispielsweise 90 % oder mehr reduziert ist oder nahezu 0 ist. Der optische Wegunterschied ergibt sich aus der Bandbreite des optischen Signals und dem effektiven Brechungsindex des Streifenwellenleiters. Gemäß einem Ausführungsbeispiel für einen Si-Wellenleiter mit einem effektiven Brechungsindex von etwa 3 und einem Wellenlängenunterschied Δλ von 30 nm bei einer maßgeblichen Wellenlänge von 1500 nm beträgt der optische Wegunterschied etwa 100 µm.

Mit dem integrierten optischen Schaltkreis 100 lässt sich die Anzahl der notwendigen Faserspleiße und damit die Anzahl potentieller Polarisationskreuzkoppelstellen, die zu Ungenauigkeiten im Sensor führen können, deutlich reduzieren. Zudem lässt sich der integrierte optische Schaltkreis 100 vergleichsweise einfach herstellen.

Die Figur 1B zeigt eine Messeinrichtung zur Magnetfeldmessung bzw. zur Messung eines Stroms durch eine Leitung 900 mittels des beschriebenen integrierten optischen Schaltkreises mit einem optischen Modul 101.

Über das Eingangstor 111 wird Licht einer Lichtquelle 110 in einen integrierten optischen Schaltkreis mit einem optischen Modul 101 eingespeist. Im optischen Schaltkreis wird das Licht polarisiert und auf zwei optische Signalpfade unterschiedlicher Weglänge gekoppelt. Von den beiden optischen Signalpfaden werden die beiden Teilsignale auf unterschiedliche Polarisationsmoden einer optischen Faserleitung 202 gekoppelt.

Die optische Faserleitung 202 führt demnach ein optisches Signal bestehend aus zwei Teilsignalen mit unterschiedlicher linearer Polarisation und Phase. Die beiden Polarisationsmoden laufen über ein Verzögerungselement 210 zu einer λ/4-Platte 220 (quarter-wave length plate), die die beiden linear polarisierten Lichtwellen in eine links zirkular und eine rechts zirkular polarisierte Lichtwelle umsetzt. Danach durchläuft das optische Signal eine optische Faserspule 310, die einen Strom führenden Leiter 900 umschlingt. Ein Reflektor 320 am Ende der Faserspule 310 reflektiert das optische Signal. Die beiden zirkularen Polarisationsmoden des reflektierten Signals werden in der λ/4-Platte 220 wieder in linear polarisierte Polarisationsmoden umgesetzt und über die optische Faserleitung 202 in das optische Modul 101 eingekoppelt. Das optische Modul 101 erzeugt aus den beiden Polarisationsmoden zwei optische Teilsignale der gleichen Polarisationsmode, kombiniert diese und führt das Kombinationssignal mit den beiden optischen Teilsignalen zu einem Detektorelement 120, das an das Ausgangstor 121 des optischen Moduls 101 angekoppelt ist. Das Detektorelement 126 registriert den Phasenunterschied zwischen den beiden optischen Teilsignalen. Eine Auswerte- und Steuereinheit 180 wertet einen Phasenunterschied zwischen den beiden Teilsignalen aus, um über eine elektrische Schnittstelle 154 eine Phasenmodulationseinrichtung im optischen Modul 101 derart anzusteuern, dass die Phasendifferenz zwischen den beiden optischen Teilsignalen nicht von einem vordefinierten Wert abweicht.

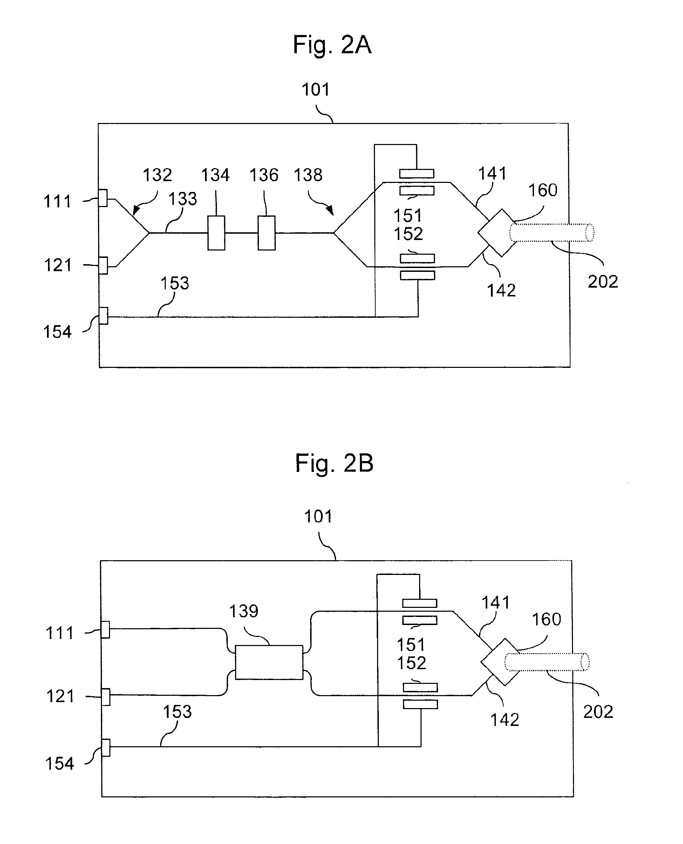

Die Figur 2A bezieht sich auf eine Ausführungsform, bei der das Richtkoppelelement ein Wellenleiter-Kombinierelement 132 und ein Wellenleiter-Verzweigungselement 138 umfasst. Das Wellenleiter-Kombinierelement 132 führt optische Signale am ersten und zweiten Tor des ersten Torpaares auf einen dritten Streifenwellenleiter 133 und ein optisches Signal vom dritten Streifenwellenleiter 133 auf das zweite Tor des ersten Torpaares. Das Wellenleiter-Verzweigungselement 138 koppelt das Signal vom dritten Streifenwellenleiter 133 zu gleichen Teilen auf den ersten und zweiten optischen Signalpfad mit den ersten und zweiten Streifenwellenleitern 141, 142 bzw. koppelt die von der optischen Faserleitung 202 empfangenen optischen Teilsignale vom ersten und zweiten optischen Signalpfad auf den dritten Streifenwellenleiter 133. Das Wellenleiter-Kombinierelement 132 sowie das Wellenleiter-Verzweigungselement 138 sind beispielsweise Y-artige Streifenstrukturen in der Technologie der im optischen Modul 101 vorgesehenen Streifenwellenleiter 141, 142, 133.

Gemäß einer Ausführungsform beruhend auf polarisationserhaltenden Streifenwellenleitern und bei Einspeisung von nicht polarisiertem Licht in das optische Modul 101 kann das Richtkoppelelement ein Polarisationselement 134 aufweisen, das Licht linear polarisiert. Gemäß einer Ausführungsform ist das Polarisationselement 134 ein integriert-optischer Polarisator, etwa vom Plasmon-Typ, wobei über einem Silizium-Nanowellenleiter ein Dünnschichtsystem aus mindestens einer dielektrischen Schicht und einer Metallschicht vorgesehen ist. Durch Anregung eines Plasmons in der Metallschicht wird eine im Silizium-Nanowellenleiter geführte Polarisationsmode quasi absorbiert. Gemäß einer anderen Ausführungsform ist das Polarisationselement 134 ein hybrid-integrierter Polarisator, etwa ein Dünnschicht-Polarisator, beispielsweise ein Glaspolarisator mit einer Dicke von 10 bis mehreren 100 µm, der in einen Graben angeordnet ist, der in das Substrat, z.B. ein Siliziumsubstrat, geätzt wurde. Wird bereits polarisiertes Licht in das optische Modul 101 eingespeist oder sind die Streifenwellenleiter selbst polarisierend, so kann das Polarisationselement 134 entfallen. Beispielsweise weisen integrierte Silizium-Nanowellenleiter eine starke Polarisationsabhängigkeit auf, d.h. die beiden linear polarisierten Eigenmoden haben stark unterschiedliche Ausbreitungskonstanten, so dass die Polarisationszustände stark voneinander entkoppelt sind. Beispielsweise können die Silizium-Nanowellenleiter derart ausgelegt sein, dass nur einer der beiden linear polarisierten Eigenmoden überhaupt ausbreitungsfähig ist, so dass der integrierte Silizium-Nanowellenleiter selbst als Polarisator wirksam ist. Der polarisierende Effekt des Silizium-Nanowellenleiters bzw. das Polarisationselement 134 sorgen dafür, dass im Interferometer nur eine lineare Polarisation geführt und moduliert wird.

Das optische Modul 101 kann ein Raumfilterelement 136 aufweisen, das im optischen Pfad zwischen dem Wellenleiter-Kombinierelement 132 und dem Wellenleiter-Verzweigungselement 138 ein Raumfilterelement 136 angeordnet ist. Das Raumfilterelement 136 unterdrückt nicht-reziproke Lichtwege, die im ansonsten reziproken integriert-optischen Interferometer durch Anregung einer zweiten oder höherer Wellenleitermode entstehen. Ein solcher zweiter Wellenleitermode kann beispielsweise im Wellenleiter-Verzweigungselement 138 angeregt werden. Bei einer konventionellen faseroptischen Realisierung des Interferometers weist die entsprechende optische Faser eine Mindestlänge auf, bei der eine solche höhere Mode vollständig abstrahlt. Bei der Realisierung in einem integriert-optischen Schaltkreis reicht dagegen die Länge des entsprechenden Abschnitts des Streifenwellenleiters dazu nicht aus. Stattdessen sieht eine Ausführungsform ein Raumfilterelement 136 zwischen dem Wellenleiter-Kombinierelement 132 und dem Wellenleiter-Verzweigungselement 138 vor.

In der gezeigten Ausführungsform weist das optische Modul 101 eine erste Modulatoreinheit 151, die in einem ersten optischen Pfad mit dem ersten Streifenwellenleiter 141 wirksam ist, und eine zweite Modulatoreinheit 152 auf, die in einem zweiten optischen Pfad mit dem zweiten Streifenwellenleiter 142 wirksam ist.

Die Figur 2B bezieht sich auf eine Ausführungsform mit einem 2:2 Richtkoppler 139 als Richtkoppelelement. Gemäß einer Ausführungsform sind die Streifenwellenleiter des integrierten optischen Schaltkreises 100 derart ausgelegt, dass nur einer der beiden linear polarisierten Eigenmoden ausbreitungsfähig ist, wie es beispielsweise bei einem hoch anisotropen Wellenleiter der Fall ist. Die Eigenmode kann beispielsweise die TE-Mode sein, bei der das elektrische Feld im Wesentlichen parallel zur Substratebene orientiert ist. Eine solche Lösung kommt ohne integriert-optischen Polarisator aus. Das von einer Lichtquelle abgegebene und über das Eingangstor 111 eingespeiste Licht wird durch den 2:2-Richtkoppler 139 auf zwei Arme einer Interferometer-Anordnung aufgeteilt. In der Interferometer-Anordnung moduliert eine Phasenmodulatoreinrichtung mit zwei Moduleinheiten 151, 152 die Phasendifferenz zwischen den optischen Signalen in den beiden Armen. Die beiden optischen Signale werden durch ein Wellenleiter-Koppelelement 160 in orthogonale, lineare Polarisationszustände einer optischen Faserleitung 202 eingekoppelt.

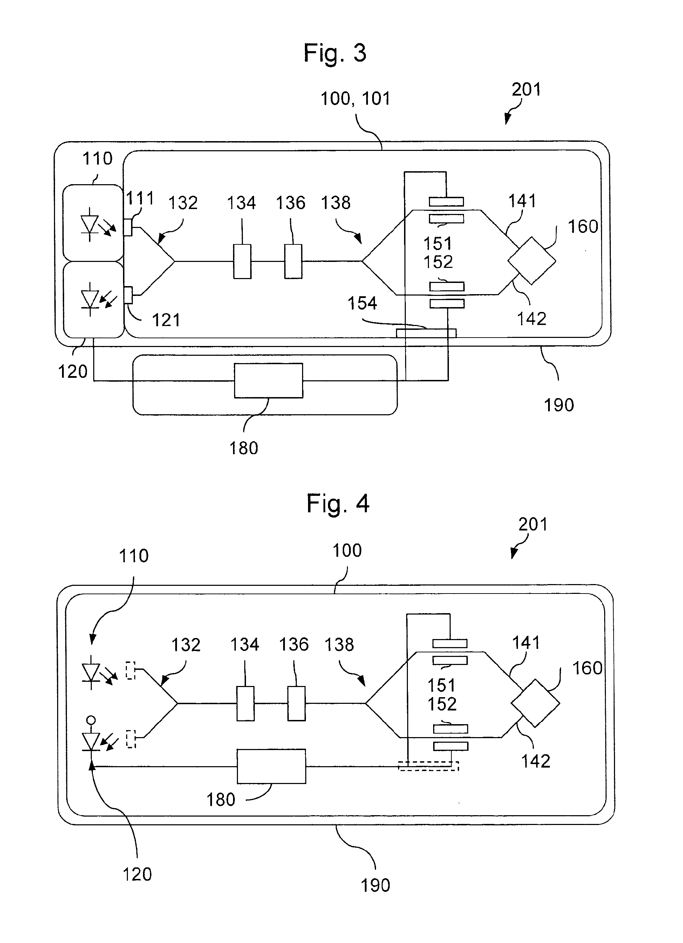

Die Figur 3 bezieht sich auf ein Sensormodul 201 mit einem integrierten optischen Schaltkreis 100, der lediglich ein optisches Modul 101 umfasst. Das von einer Lichtquelle 110 abgestrahlte Licht wird über ein Eingangstor 1 11 in das optische Modul 101 des integrierten optischen Schaltkreises 100 eingekoppelt, durch ein Wellenleiter-Kombinierelement 132 auf ein Polarisationselement 134 geführt, dort linear polarisiert und durch ein Wellenleiter-Verzweigungselement 138 auf zwei asymmetrische Streifenwellenleiter 141, 142 verteilt, wobei das Wellenleiter-Verzweigungselement 138 einen Phasenunterschied zwischen den in den beiden Streifenwellenleitern 141, 142 geführten optischen Signalen erzeugen kann. Die beiden Streifenwellenleiter 141, 142 werden in einem Wellenleiter-Koppelelement 160 zusammengeführt, das die beiden in den beiden Streifenwellenleitern 141, 142 geführten optischen Signale in eine optische Faserleitung 202 einspeist, die mit einer Stirnseite oberhalb des Wellenleiter-Koppelelements 160 angeordnet ist. Die optische Faserleitung 202 ist mit einem magnetfeldempfindlichen, faseroptischen Sensorkopf verbunden, in dem das in die optische Faserleitung 202 eingekoppelte optische Signal reflektiert wird und in dem die Phasendifferenz zwischen den zwei Polarisationsmoden in Abhängigkeit der Stärke eines Magnetfelds, dem der Sensorkopf ausgesetzt ist, verändert wird.

Das im Sensorkopf reflektierte optische Signal mit den beiden Polarisationsmoden wird über das Wellenleiter-Koppelelement 160 auf die beiden Streifenwellenleiter 141, 142 zurückgekoppelt, wobei im Wesentlichen die eine Polarisationsmode in den ersten Streifenwellenleiter 141 und die andere Polarisationsmode in den anderen Streifenwellenleiter 142 eingekoppelt wird. Da das Wellenleiter-Koppelelement 160 reziprok wirkt, wird dabei die Änderung in der Polarisationsrichtung im zweiten Streifenwellenleiter 142 wieder umgekehrt. Die beiden in den beiden Streifenwellenleitern 141, 142 geführten optischen Teilsignale haben somit dieselbe Polarisation, weisen aber eine Phasendifferenz zueinander auf, die eine Information über die Stärke des Magnetfelds beinhaltet, dem der Sensorkopf ausgesetzt ist.

Das Wellenleiter-Verzweigungselement 138 führt die beiden optischen Teilsignale zusammen, wobei das Raumfilterelement 136 höhere Moden filtert bzw. abstrahlt, die z.B. durch die Führung der optischen Signale über das Wellenleiter-Verzweigungselement 138 angeregt worden sind. Das Wellenleiter-Kombinierelement 132 koppelt die beiden sich überlagernden optischen Teilsignale auf ein Ausgangstor 121 des optischen Moduls 101, an das ein optisches Detektorelement 120 gekoppelt ist. Aus der Verschiebung eines Interferenzmusters, das sich aus der Überlagerung zwischen den beiden phasenverschobenen optischen Teilsignalen ergibt, ermittelt eine Auswerte- und Steuereinheit 180 die Stärke des Magnetfelds bzw. die Stärke eines das Magnetfeld erzeugenden Stroms.

Gemäß einer Ausführungsform wird das Sensormodul 201 im Closed-Loop-Verfahren betrieben, wobei die Auswerte- und Steuereinheit 180 eine zwischen dem Wellenleiter-Verzweigungselement 138 und dem Wellenleiter-Koppelelement 160 angeordnete Phasenmodulatoreinrichtung mit Modulatoreinheiten 151, 152 derart steuert, dass die im optischen Detektorelement 120 ermittelte Phasendifferenz von einem vorbestimmten Bezugswert nicht abweicht. Gemäß einer Ausführungsform gibt die Auswerte- und Steuereinheit 180 dazu elektrische Signale aus, die zu einer elektrische Schnittstelle des optischen Moduls 101 übertragen werden. Im optischen Modul 101 verbinden elektrische Leitungen die elektrische Schnittstelle mit den Modulatoreinheiten 151, 152.

Die Lichtquelle 110 ist beispielsweise ein hybrider SLD-Chip (super luminescence diode), der separat hergestellt und beispielsweise durch Stirnflächenkopplung entsprechender Wellenleiterfacetten oder durch Flip-Chip-Montage an den integrierten optischen Schaltkreis 100 optisch angekoppelt ist. Das optische Detektorelement 120 kann zusammen mit der Lichtquelle 110 auf einem gemeinsamen Chip prozessiert und zusammen mit der Lichtquelle 110 an den integrierten optischen Schaltkreis 100 angekoppelt werden. Das Vorsehen von Lichtquelle 110 und Detektorelement 120 außerhalb des integrierten optischen Schaltkreises 100 ermöglicht den Einsatz gebräuchlicher Lichtquellen und Detektorelementen. Gemäß einer weiteren Ausführungsform ist nur das Detektorelement 120 auf dem integrierten optischen Schaltkreis 100 integriert, z.B. auf Ge- oder III-V-Basis, während die Lichtquelle 110 auf einem separat prozessierten Chip vorgesehen ist. Eine solche Ausführungsform reduziert den Montageaufwand bei der Herstellung, insbesondere wenn der integrierte optische Schaltkreis mehrere optische Module aufweist, die jeweils verschiedenen Detektorelementen zugeordnet sind, aber aus derselben Lichtquelle gespeist werden können.

Die Auswerte-Steuerelektronik 180 zur Datenverarbeitung kann in den integrierten optischen Schaltkreis integriert und zusammen mit den Streifenwellenleitern und Modulatoren auf einem gemeinsamen Substrat ausgebildet sein. Gemäß der in der Figur 3 gezeigten Ausführungsform ist die Auswerte- und Steuerelektronik 180 auf einem separaten Silizium-Chip realisiert.

Das Sensormodul 201 umfasst ferner ein mit dem integrierten optischen Schaltkreis 100 thermisch gekoppeltes thermoelektrisches Element 190 (TEC, Peltier-Element). Das thermoelektrische Element 190 hält die Temperatur des integrierten optischen Schaltkreises 100 bei einer vorgegebenen Temperatur. Gemäß einer Ausführungsform hält das thermoelektrische Element 190 auch die Temperatur der Lichtquelle 110 bzw. die Temperatur von Lichtquelle 110 und Detektorelement 120 konstant. Das thermoelektrische Element 190 unterdrückt temperaturabhängige Polarisationskreuzkopplungen. Zudem kann bei einer Temperaturstabilisierung des integrierten optischen Schaltkreises auf etwa 0.1°C eine resultierende Phasenverschiebung konstant gehalten und gegebenenfalls kalibriert werden.

Die in der Figur 4 dargestellte Ausführungsform zeigt eine monolithisch integrierte Lösung, bei der das optische Modul 101, die Lichtquelle 110, das Detektorelement 120 und die Auswerte-Steuereinheit 180 auf demselben Substrat ausgebildet sind und thermisch an ein thermoelektrisches Element 190 gekoppelt sind. Das "Eingangstor" bzw. das "Ausgangstor" des optischen Moduls, sind Streifenwellenleiter die das Richtkoppelelement mit einer Lichtquelle 110 bzw. einem Detektorelement 120 optisch verbinden.

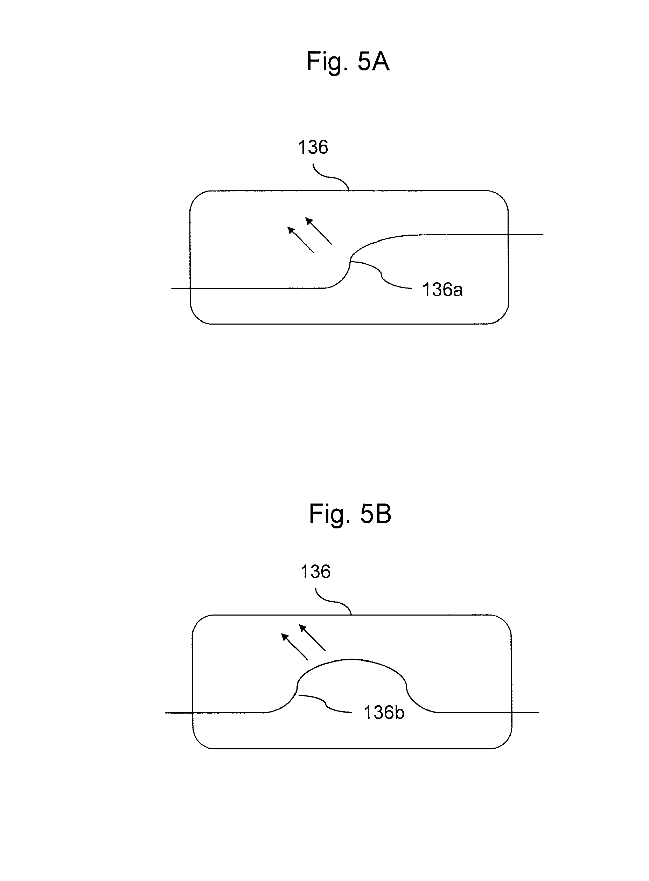

Die Figuren 5A bis 5D beziehen sich auf Ausführungsformen eines Raumfilterelements 136.

In der Ausführungsform gemäß der Figur 5B erfolgt die Abstrahlung höherer Wellenleitermoden durch eine einzelne Krümmung im Streifenwellenleiter 136a.

In der Ausführungsform gemäß der Figur 5b umfasst der Streifenwellenleiter 136b einen stark gekrümmten Wellenleiterabschnitt mit zwei gegensinnigen Krümmungen. Der Wellenleiterabschnitt formt z.B. einen Halbkreis. Ein solcher doppeltgekrümmter Wellenleiterabschnitt unterdrückt die Führung höherer Moden.

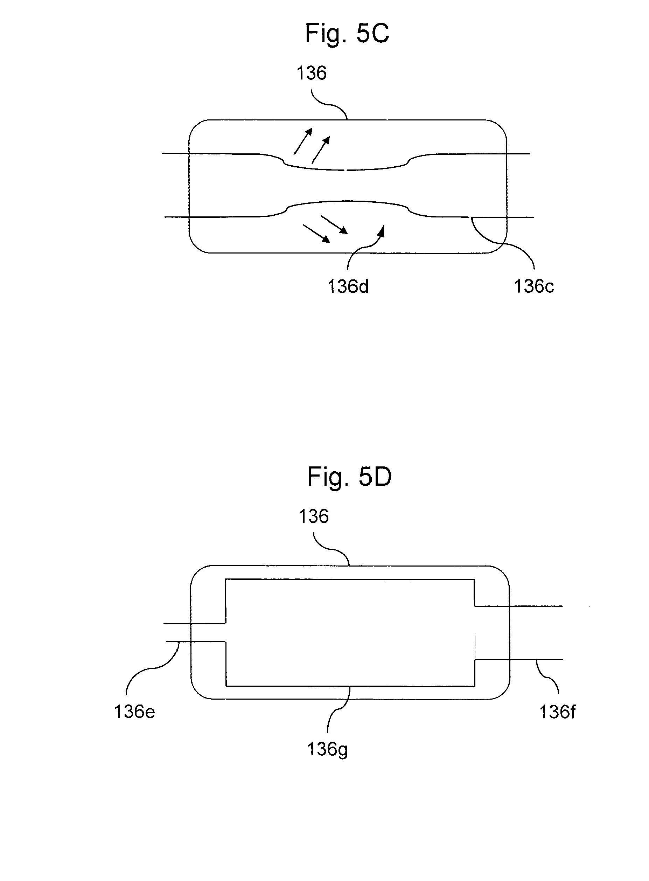

Die Figur 5C bezieht sich auf ein Ausführungsbeispiel in dem ein Streifenwellenleiter 136c einen Abschnitt mit einer Verengung 136d aufweist. Der Verlauf der Verengung folgt einer mathematischen Funktion, die es erlaubt, die Grundmode nahezu ungedämpft passieren zu lassen.

Die Figur 5D bezieht sich auf ein Raumfilterelement 136 mit einem Multimode-Interferenzbereich (MMI-Struktur) 136g und unterschiedlichen Leiterbreiten für den eingangsseitigen Streifenwellenleiter 136e und den ausgangsseitigen Streifenwellenleiter 136f.

Gemäß einer Ausführungsform weist der integrierte optische Schaltkreis genau eines der optischen Module 101 umfassend ein Richtkoppelelement 130, eine Phasenmodulatoreinheit 150 und ein Auskoppelelement 160 auf. Ein integrierter optischer Schaltkreis mit genau einem solchen optischen Modul 101 ist beispielsweise zur Messung von Gleichstrom oder Wechselstrom in genau einem Leiter geeignet.

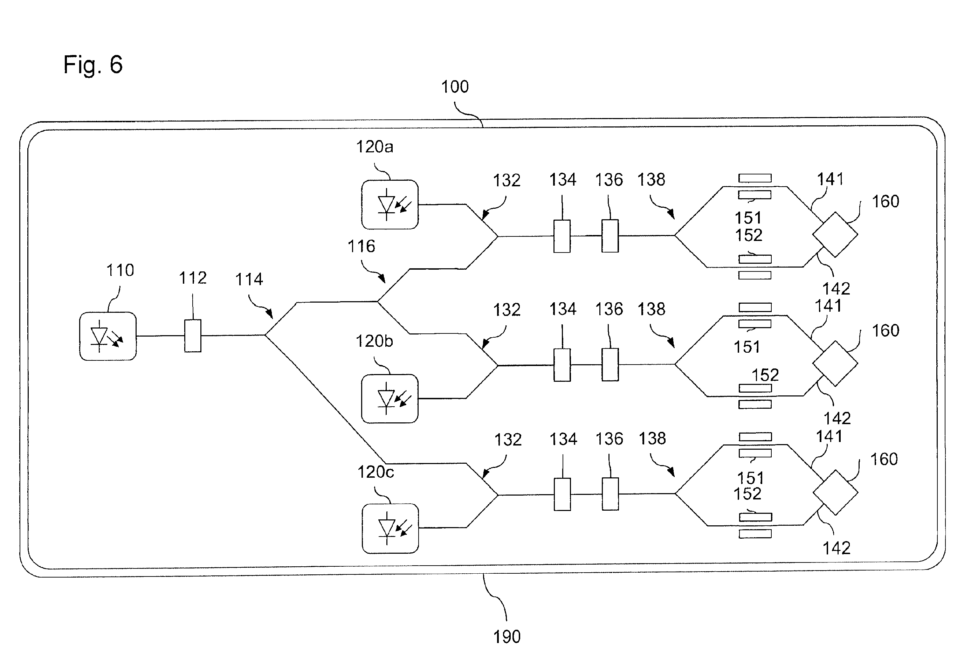

Gemäß einer in Figur 6 gezeigten Ausführungsform umfasst der integrierte optische Schaltkreis 100 genau drei oder mehr im Prinzip identische optische Module. Jedes optische Modul umfasst ein Richtkoppelelement, beispielsweise umfassend ein Wellenleiter-Kombinierelement 132, ein Polarisationselement 134, ein Raumfilterelement 136 und ein Wellenleiter-Verzweigungselement 138, sowie eine Phasenmodulatoreinheit, beispielsweise mit einer ersten, einem ersten Streifenwellenleiter 141 zugeordneten Modulatoreinheit 151 und einer zweiten, einem zweiten Streifenwellenleiter 142 zugeordneten Modulatoreinheit 152, sowie einem Wellenleiter-Koppelelement 160 zur Ankopplung des ersten und des zweiten Streifenwellenleiters 141, 142 an eine optische Faserleitung 202. Jedem Ausgangstor der optischen Module 101 ist ein Detektorelement 120a, 120b, 120c zugeordnet, das optisch an das jeweilige Ausgangstor angekoppelt ist. Dagegen sind die Eingangstore der drei optischen Module an dieselbe Lichtquelle 110 gekoppelt, beispielsweise über ein 1:3 Wellenleiter-Verzweigungselement 114/116.

Gemäß einer Ausführungsform ist zwischen der Lichtquelle 110 und dem 1:3-Wellenleiter-Verzweigungselement 114/116 ein zusätzliches Polarisationselement 112 vorgesehen. Das 1:3-Wellenleiter-Verzweigungselement 114/116 besteht beispielsweise aus einem ersten Strahlteiler 114, der ein optisches Eingangssignal im Verhältnis 67% : 33% aufteilt, und einen zweiten Strahlteiler 116, der das 67%-ige Ausgangssignal des ersten Strahlteilers 114 gleichmäßig auf die beiden ausgangsseitigen Streifenwellenleiter verteilt. Die Lichtquelle 110 und die Detektorelemente 120a, 120b, 120c können entweder monolithisch auf demselben Substrat integriert sein, auf dem auch die optischen Module integriert sind. Gemäß einer anderen Ausführungsform werden sie auf separaten Chips prozessiert und optisch an das optische Modul 101 angekoppelt.

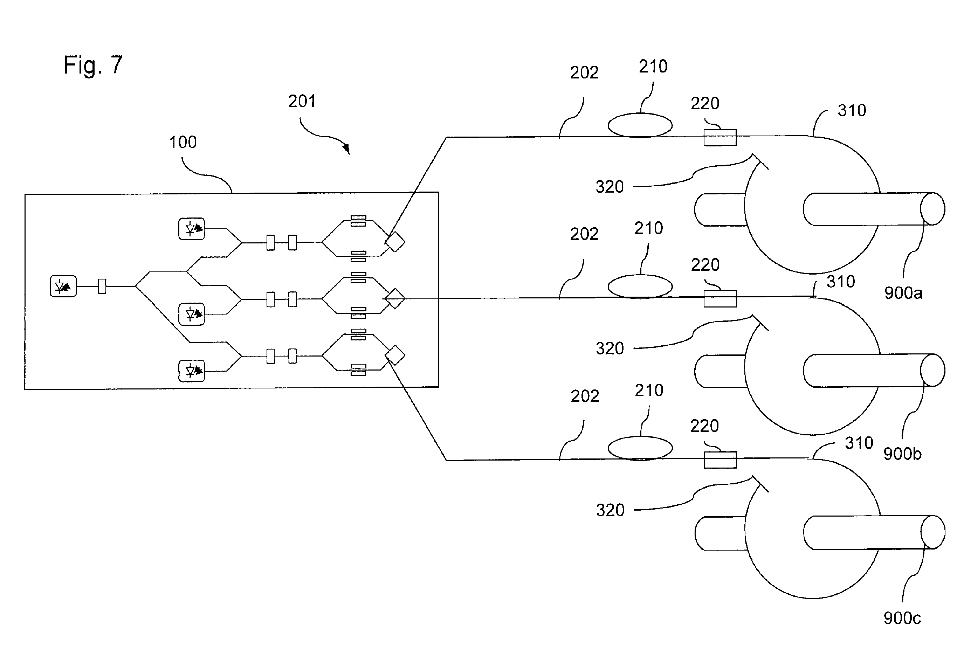

Die Figur 7 zeigt eine Ausführungsform einer Messeinrichtung 901, zur Messung in einem Drei-Phasen-System mit drei stromführenden Leitern 900a, 900b, 900c mittels des integrierten optischen Schaltkreises 100 der Figur 6. Der Aufbau ist analog dem in der Figur 1B gezeigten Aufbau. Jedem der stromführenden Leiter 900a, 900b, 900c ist eines der optischen Module des optischen Schaltkreises 100 zugeordnet.

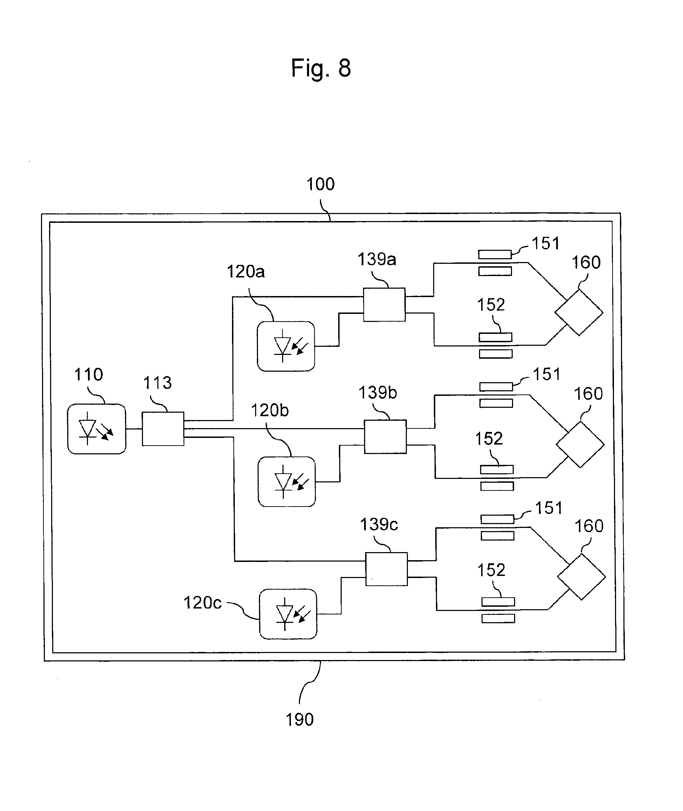

Die Figur 8 bezieht sich auf eine weitere Ausführungsform für einen integrierten optischen Schaltkreis mit drei im Wesentlichen gleichartigen optischen Modulen zur Messung von Strömen in Drei-Phasen-Systemen. Die Ausführungsform beruht auf einem 1:3-Teiler 113, der das Signal der Lichtquelle 110 auf die drei Eingangstore der drei optischen Module verteilt. Alle Streifenwellenleiter sind beispielsweise Nanowellenleiter, in denen nur einer der beiden linear polarisierten Eigenmoden ausbreitungsfähig ist, so dass auf integriert-optische Polarisatoren verzichtet werden kann. Jedes der optischen Module weist einen 2:2-Richtkoppler 139a, 139b, 139c auf, der jeweils ein optisches Signal an einem ersten Tor eines ersten Torpaares auf ein erstes und zweites Tor eines zweiten Torpaares und optische Signale an den Toren des zweiten Torpaares auf das zweite Tor des ersten Torpaares führt. Der Leistungsteiler kann als MMI-Koppler ausgelegt sein (Multimode-Interferenz-Koppler). Die Ausführungsform vermeidet Wellenleiterkreuzungen. Die Lichtquelle 110 und die Detektorelemente 120a, 120b, 120c können entweder monolithisch integriert sein oder separat hergestellt und optisch an die optischen Module angekoppelt sein. Der integrierte optische Schaltkreis 100 ist thermisch mit einem thermoelektrischen Element gekoppelt, das so gesteuert wird, dass der integrierte optische Schaltkreis mit einer Abweichung von der Betriebstemperatur von weniger als 0,1°C betrieben werden kann.

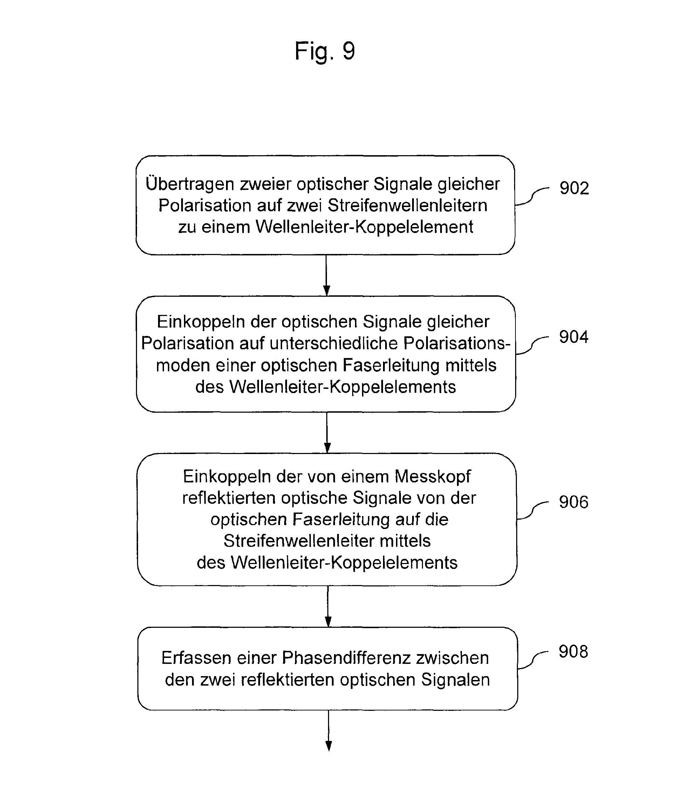

Die Figur 9 bezieht sich auf ein Verfahren zur Strommessung auf Grundlage des Faraday-Effekts mittels eines integrierten optischen Schaltkreises. Im integrierten optischen Schaltkreis werden ein erstes und ein zweites optisches, polarisiertes Signal über einen ersten bzw. einen zweiten Streifenwellenleiter zu einem Wellenleiter-Koppelelement übertragen (902). Über das Wellenleiter-Koppelelement werden das erste und das zweite optische Signal auf eine optische Faserleitung eines Messkopfs eingekoppelt (904), wobei das über den zweiten Streifenwellenleiter übertragene optische Signal auf eine andere Polarisationsmode der optischen Faserleitung gekoppelt wird als das erste optische Signal. Das vom Messkopf reflektierte optische Signal enthält zwei optische Teilsignale unterschiedlicher Polarisation. Das erste optische Teilsignal wird am Wellenleiter-Koppelelement in den ersten Streifenwellenleiter und das zweite optische Teilsignal in den zweiten Streifenwellenleiter eingekoppelt (906), wobei die Polarisation reziprok gedreht wird. Die beiden aus dem reflektierten Signal gewonnenen optischen Teilsignale in den beiden Streifenwellenleitern haben dieselbe Polarisation und weisen zueinander eine Phasenverschiebung auf, die der Stärke eines Magnetfelds, dem der Messkopf ausgesetzt ist, entspricht. Die Phasendifferenz wird erfasst (908) und aus der Phasendifferenz auf die Stromstärke zurück geschlossen.

Gemäß einer Ausführungsform wird die Phasendifferenz zwischen dem ersten und zweiten optischen Signal mittels eines Phasenmodulators auf einen vorgegebenen Wert geregelt.

## Patentansprüche

1. Ein integrierter optischer Schaltkreis zur Strommessung auf Grundlage des Faraday-Effekts, umfassend mindestens ein optisches Modul (101), das aufweist:
einen ersten Streifenwellenleiter (141);
einen zweiten Streifenwellenleiter (142);
ein Wellenleiter-Koppelelement (160), das geeignet ist, ein erstes optisches Signal vom ersten Streifenwellenleiter (141) und ein zweites optisches Signal vom zweiten Streifenwellenleiter (142) auf eine optische Faserleitung (202) zu koppeln, wobei gleiche Polarisationsmoden des ersten und zweiten optischen Signals auf unterschiedliche Polarisationsmoden der optischen Faserleitung (202) gekoppelt und optische Signale von der optischen Faserleitung (202) in Abhängigkeit vom Polarisationsmode auf den ersten und zweiten Streifenwellenleiter (141, 142) gekoppelt werden.

2. Der integrierte optische Schaltkreis gemäß Anspruch 1, **gekennzeichnet durch**
eine steuerbare Phasenmodulatoreinrichtung (150), die geeignet ist, eine Phase zwischen gleichen Polarisationsmoden des ersten und des zweiten optischen Signals zu beeinflussen.

3. Der integrierte optische Schaltkreis gemäß Anspruch 2, **dadurch gekennzeichnet, dass**
die Phasenmodulatoreinrichtung (150) genau eine Modulatoreinheit (151) umfasst, die einem der beiden Streifenwellenleiter (141, 142) zugeordnet ist.

4. Der integrierte optische Schaltkreis gemäß Anspruch 2, **dadurch gekennzeichnet, dass**
die Phasenmodulatoreinrichtung (150) eine Modulatoreinheit (151), die auf das erste optische Signal wirkt, und eine zweite Modulatoreinheit (152), die auf das zweite optische Signal wirkt, umfasst.

5. Der integrierte optische Schaltkreis nach einem der Ansprüche 1 bis 4, **gekennzeichnet durch**
ein Richtkoppelelement (130), das geeignet ist, ein optisches Eingangssignal an einem Eingangstor (111) auf den ersten und den zweiten Streifenwellenleiter (141, 142) und optische Signale vom ersten und zweiten Streifenwellenleiter (141, 142) auf ein Ausgangstor (121) zu koppeln;
einen ersten optischen Signalpfad zwischen dem Richtkoppelelement (130) und dem Wellenleiter-Koppelelement (160), umfassend den ersten Streifenwellenleiter (141); und
einen zweiten optischen Signalpfad zwischen dem Richtkoppelelement (130) und dem Wellenleiter-Koppelelement (160), umfassend den zweiten Streifenwellenleiter (142), wobei eine optische Weglänge des zweiten optischen Signalpfads von der des ersten optischen Signalpfads abweicht, so dass ein Interferenzkontrast der optischen Signal im Wellenleiter-Koppelelement (160) im Vergleich zu identischen Weglängen um mindestens 50 % reduziert ist.

6. Der integrierte optische Schaltkreis gemäß Anspruch 5, **dadurch gekennzeichnet,**
**dass** eine Differenz der optischen Weglängen im ersten und zweiten optischen Signalpfad so bemessen ist, dass der Interferenzkontrast der optischen Signale im Wellenleiter-Koppelelement (160) im Wesentlich 0 ist.

7. Der integrierte optische Schaltkreis gemäß einem der Ansprüche 5 bis 6, **dadurch gekennzeichnet, dass** das Richtkoppelelement (130) umfasst:
ein Wellenleiter-Kombinierelement (132), das geeignet ist, optische Signale am Eingangstor (111) auf einen dritten Streifenwellenleiter (133) und ein optisches Signal vom dritten Streifenwellenleiter (133) auf das Ausgangstor (121) zu koppeln; und
ein Wellenleiter-Verzweigungselement (138), das geeignet ist, ein optisches Signal vom dritten Streifenwellenleiter (133) auf den ersten und zweiten optischen Signalpfad und optische Signale vom ersten und zweiten optischen Signalpfad auf den dritten Streifenwellenleiter (133) zu koppeln.

8. Der integrierte optische Schaltkreis gemäß Anspruch 7, **dadurch gekennzeichnet, dass** das Richtkoppelelement (130) umfasst:
ein Raumfilterelement (236), das geeignet ist, höhere Wellenleitermoden abzustrahlen.

9. Der integrierte optische Schaltkreis gemäß Anspruch 7, **dadurch gekennzeichnet, dass**
das Raumfilterelement (136) als Krümmung oder Querschnittsänderung des dritten Streifenwellenleiters (133) ausgeführt ist.

10. Der integrierte optische Schaltkreis gemäß einem der Ansprüche 7 bis 9, **dadurch gekennzeichnet, dass** das Richtkoppelelement (130) umfasst:
ein integriert-optisches Polarisationselement (134).

11. Der integrierte optische Schaltkreis gemäß einem der Ansprüche 5 bis 10, **gekennzeichnet durch**
genau ein optisches Modul (101),
eine über das Eingangstors (111) an das Richtkoppelelement (130) angekoppelte Lichtquelle (110), und
ein über das Ausgangstor (121) an das Richtkoppelelement (130) angekoppeltes Detektorelement (120), das geeignet ist, eine Phaseninformation auszugeben, die eine Phasenbeziehung zwischen den Polarisationsmoden der von der optischen Faserleitung (202) in den ersten und zweiten Streifenwellenleiter (141, 142) eingekoppelten optischen Signale beschreibt.

12. Der integrierte optische Schaltkreis gemäß Anspruch 11, **gekennzeichnet durch**
eine Auswerte- und Steuereinheit (180), die geeignet ist, aufgrund der Phaseninformation die Phasenmodulatoreinrichtung (150) derart zu steuern, dass die Phase zwischen den Polarisationsmoden der von der optischen Faserleitung (202) in dem ersten und zweiten Streifenwellenleiter (141, 142) eingekoppelten optischen Signale von einem vorgegebenen Wert nicht abweicht.

13. Der integrierte optische Schaltkreis gemäß einem der Ansprüche 5 bis 10, **gekennzeichnet durch**
genau drei oder mehr optische Module (101).

14. Der integrierte optische Schaltkreis gemäß Anspruch 13, **gekennzeichnet durch**
eine über Streifenwellenleiter und Wellenleiterverzweigungen an die Eingangstore (111) der optischen Module (101) angekoppelte Lichtquelle (110), und
mindestens drei an die Ausgangstore der optischen Module (101) gekoppelte Detektorelemente (120a, 120b, 120c), wobei jedes Detektorelement (120a, 120b, 120c) geeignet ist, eine Phaseninformation auszugeben, die eine Phasenbeziehung zwischen den Polarisationsmoden der von einer dem jeweiligen optischen Modul (101) zugeordneten optischen Faserleitung (202) in den ersten und zweiten Streifenwellenleiter (141, 142) des jeweiligen optischen Moduls (101) eingekoppelten optischen Signale beschreibt.

15. Der integrierte optische Schaltkreis gemäß den Ansprüchen 13 oder 14, **gekennzeichnet durch**
eine Auswerte- und Steuereinheit (180), die geeignet ist, aufgrund der Phaseninformation die Phasenmodulatoreinrichtungen (150) in den jeweiligen optischen Modulen (101) derart zu steuern, dass eine Phasendifferenz zwischen den Polarisationsmoden der von der dem jeweiligen optischen Modul (101) zugeordneten optischen Faserleitung (202) in den jeweiligen ersten und zweiten Streifenwellenleitern (141, 142) eingekoppelten optischen Signale von einem jeweils vorgegebenen Wert nicht abweicht.

16. Der integrierte optische Schaltkreis gemäß den Ansprüchen 11 bis 15, **dadurch gekennzeichnet,**
**dass** die Lichtquelle (110) im optischen Schaltkreis (100) monolithisch integriert ist.

17. Der integrierte optische Schaltkreis gemäß den Ansprüche 11 bis 16, **dadurch gekennzeichnet,**
**dass** die Auswerte- und Steuereinheit (180) monolithisch im optischen Schaltkreis integriert ist.

18. Ein Sensormodul **gekennzeichnet durch**
einen integrierten optischen Schaltkreis (100) nach einem der vorangehenden Ansprüche, und
ein mit dem integrierten optischen Schaltkreis (100) thermisch gekoppeltes thermoelektrisches Element (190).

19. Eine Messeinrichtung zur Strommessung auf Grundlage des Faraday-Effekts, umfassend
einen integrierten optischen Schaltkreis (100) nach einem der Ansprüche 1 bis 17 oder ein Sensormodul nach Anspruch 18, und
einen magnetfeldempfindlichen faseroptischen Sensorkopf, der zur Ankopplung an das Wellenleiter-Koppelelement (160) geeignet ist.

20. Ein Verfahren zur Strommessung auf Grundlage des Faraday-Effekts mittels eines integrierten optischen Schaltkreises (100) umfassend
Übertragen eines ersten optischen Signals über einen ersten Streifenwellenleiter (141) und eines zweiten optischen Signals über einen zweiten Streifenwellenleiter (142) zu einem Wellenleiter-Koppelelement (160), wobei das erste und das zweite optische Signal dieselben Polarisationsmode aufweisen;
Einkoppeln des ersten und des zweiten optischen Signals mittels eines Wellenleiter-Koppelelements (160) auf eine optische Faserleitung (202) eines Messkopfs, wobei das erste und das zweite optische Signal auf unterschiedliche Polarisationsmoden der optischen Faserleitung gekoppelt werden;
Einkoppeln eines vom Messkopf reflektierten optischen Signals mit zwei Teilsignalen unterschiedlicher Polarisation von der optischen Faserleitung (202) auf den ersten und zweiten Streifenwellenleiter (141, 142) entsprechend der Polarisationsmode; und
Erfassen einer Phasendifferenz zwischen den beiden von der optischen Faserleitung (202) auf den ersten und zweiten Streifenwellenleiter (141, 142) gekoppelten optischen Signalen.

21. Das Verfahren nach Anspruch 20, **gekennzeichnet durch**
Regeln einer Phasendifferenz zwischen dem ersten und zweiten optischen Signal auf einen vorgegebenen Wert in Abhängigkeit der Phasendifferenz mittels einer Phasenmodulatoreinrichtung (150).
